# EUROPÄISCHE PATENTSCHRIFT

(11) **EP 3 161 896 B1**
(45) Veröffentlichungstag und Bekanntmachung des Hinweises auf die Patenterteilung: **21.08.2019**
(21) Anmeldenummer: 15727365.7
(22) Anmeldetag: 01.06.2015
(51) Int. Cl.: H01M 10/42, H01M 10/48, H05K 1/18

(54) **ELEKTRISCHER VERBINDER FÜR EIN BATTERIEMODUL**
ELECTRICAL CONNECTOR FOR A BATTERY MODULE
ÉLÉMENT DE LIAISON ÉLECTRIQUE POUR MODULE DE BATTERIE

(30) Priorität: 26.06.2014 DE 102014212247
(43) Veröffentlichungstag der Anmeldung: 03.05.2017
(73) Patentinhaber: Robert Bosch GmbH, 70442 Stuttgart (DE)
(72) Erfinder: SCHWINDT, Emilia, 70563 Stuttgart (DE); MUELLER, Carsten, 70469 Stuttgart (DE); BAUMANN, Stefan, 72657 Altenriet (DE); RUEHLE, Andreas, 74321 Bietigheim-Bissingen (DE)
(86) Internationale Anmeldenummer: PCT/EP2015/062119
(87) Internationale Veröffentlichungsnummer: WO 2015/197311

(56) Entgegenhaltungen:
- DE-A1-102011 016 373
- DE-A1-102012 212 368
- US-A1- 2013 244 499
- US-A1- 2014 017 533

## Beschreibung

### Stand der Technik

Die Erfindung geht aus von einem elektrischen Verbinder für ein Batteriemodul.

Aus dem Stand der Technik sind elektrische Verbinder bekannt, welche mindestens eine Batteriezelle eines Batteriemoduls elektrisch leitend mit einer Erfassungseinheit verbinden, beispielsweise mittels Verschweißung von elektrisch leitenden Drähten mit der Batteriezelle und der Erfassungseinheit.

### Offenbarung der Erfindung

Nachteilig an dem bekannten Stand der Technik ist, dass für eine Herstellung und Montage einer elektrisch leitenden Verbindung zwischen einer Batteriezelle und einer Erfassungseinheit verschiedene Herstellungsschritte notwendig sind. So wird ein elektrischer Verbinder beispielsweise aus elektrisch leitenden Drähten hergestellt, wobei die Drähte eine exakte Länge und eine Biegung aufweisen müssen. Jeder elektrische Verbinder wird mit mindestens einer Batteriezelle und einer Erfassungseinheit verschweißt oder verklebt. Die elektrisch leitenden Drähte werden anschließend zu einem Kabelbaum zusammengefasst.

DE10 2011 016 373 A1 offenbart einen Batterieblock mit mehreren Batteriezellen, enthaltend flexible Leiterplatten und biegsame Kontaktelemente.

### Vorteile der Erfindung

Die erfindungsgemäße Vorgehensweise mit den kennzeichnenden Merkmalen der unabhängigen Ansprüche weist demgegenüber den Vorteil auf, dass eine Zellüberwachungseinheit mittels mindestens eines Bonddrahts und/oder mindestens eines Bondbands mit einer flexiblen Leiterplatte elektrisch leitend verbunden ist und durch eine Vorrichtung zum Arretierung, reversibel mit der flexiblen Leiterplatte mechanisch verbunden ist.

Weitere vorteilhafte Ausführungsformen der vorliegenden Erfindung sind Gegenstand der Unteransprüche.

Vorteilhafterweise wird als Material für den Bonddraht und/oder das Bondband Aluminium, Aluminium-Silizium, Kupfer oder Gold zur Verringerung von Leitungsverlusten verwendet. Weiter vorteilhaft können der Bonddraht und/oder das Bondband mittels Walzplattieren hergestellt werden, beispielsweise durch Aufbringen einer Kupferschicht auf eine Aluminiumschicht, wobei diese Verbindung mechanisch unlösbar ist.

Vorteilhafterweise weist der Bonddraht in Abhängigkeit einer spezifischen Energiedichte, beispielsweise 200Wh/kg, und einer Anzahl der Batteriezellen des betreffenden Batteriemoduls einen Durchmesser zwischen 100µm und 500µm auf, so dass ein maximaler Stromfluss von beispielsweise 20A durch den Bonddraht gewährleistet ist, ohne dass der Bonddraht beispielsweise durch Wärmeeinwirkung beschädigt wird.

Vorteilhafterweise weist das Bondband in Abhängigkeit einer spezifischen Energiedichte, beispielsweise 240Wh/kg, und einer Anzahl der Batteriezellen des betreffenden Batteriemoduls einen rechteckigen Querschnitt mit einer Breite zwischen 30µm und 3000µm und einer Höhe zwischen 10µm und 500µm auf, so dass ein maximaler Stromfluss von beispielsweise 80A durch das Bondband gewährleistet ist, ohne dass das Bondband beispielsweise durch Wärmeeinwirkung beschädigt wird.

Vorteilhafterweise weist der Bonddraht und/oder das Bondband eine Länge zwischen 1mm und 30mm auf, so dass eine mechanische Stabilität sichergestellt ist und geringe Leitungswiderstände erreicht werden.

Vorteilhafterweise umfasst die Zellüberwachungseinheit mindestens einen Spannungssensor, einen Stromsensor, einen Temperatursensor, einen Widerstand und/oder ein Batteriemanagementsystem, so dass durch die Zellüberwachungseinheit beispielsweise eine Spannung einzelner Batteriezellen erfasst wird.

Vorteilhafterweise ist die Zellüberwachungseinheit innerhalb eines Bereich der flexiblen Leiterplatte angeordnet und die Zellüberwachungseinheit und die flexible Leiterplatte miteinander verklebt, verschraubt, verlötet, verschweißt und/oder mittels Arretierungen mechanisch verbunden, wodurch eine besonders hohe Festigkeit erreicht wird und eine Ausfallrate beispielsweise aufgrund von Vibrationen reduziert wird.

Vorteilhafterweise weist die flexible Leiterplatte als Grundmaterial PET (Polyester), PEM (Polyethylennaphtalat) und/oder PI (Polyimid) auf, wobei Leiterbahnen mittels Druckverfahren oder Lithographie auf das Grundmaterial aufgebracht werden.

Um eine elektrische leitende Verbindung zwischen dem Bonddraht und/oder dem Bondband und einer Stromschiene, einer Leiterbahn und/oder einer Kontaktierungsflächen herzustellen, werden verschiedene Verfahrensvarianten wie ein Thermokompressionsbonden (TC-Bonden), ein Thermosonic-Ball-Wedge-Bonden (TS-Bonden) und/oder ein Ultraschall-Wedge-Wedge-Bonden (US-Bonden) eingesetzt.

Diese Verfahren werden beispielsweise anhand eines verwendeten Materials der Bonddrähte oder des Bondbands ausgewählt. So wird das TC-Bonden für ein Drahtbonden selten eingesetzt, da die für eine Verbindung nötigen hohen Kräfte und Temperaturen zu einer Beschädigung der Verbindungselemente führen können, wohingegen das Verfahren jedoch für ein Bandbonden geeignet ist. Wird Gold oder Kupfer als Material für die Bonddrähte oder Bondbänder verwendet, so eignet sich das TS-Bonden. Wird hingegen Aluminium bzw. Aluminium-Silizium als Material für die Bonddrähte oder Bondbänder verwendet, so eignet sich vorteilhafterweise das US-Bonden.

Vorteilhafterweise ist eine bauraumoptimierte Anordnung von Batteriezellen aufgrund des, im Vergleich zu bisher verwendeten Kabelbäumen, geringeren Platzbedarfs der flexiblen Leiterplatte, der Zellüberwachungseinheit und den Bonddrähten und/oder den Bondbändern möglich.

Vorteilhafterweise ist eine neue Geometrie und/oder eine neue Anordnung von Batteriezellen aufgrund der mechanischen Flexibilität der Bonddrähte und/oder der Bondbänder als Zellverbinder möglich. Vorteilhafterweise lassen sich neue Geometrien mit einem geringen Änderungsaufwand an Bondmaschinen umsetzen.

Vorteilhafterweise ist eine Reparatur von defekten elektrischen Verbindungen, bei einer Verwendung von flexiblen Leiterplatten, Zellüberwachungseinheiten, Bonddrähten und/oder Bondbändern, im Vergleich zu bisherigen Verbindungstechniken mit vergleichsweise geringem Aufwand möglich.

Vorteilhafterweise sind weniger Herstellungsschritte zur Kontaktierung von Batteriezellen und dem Verbindungsmittel durch Bonddrähte und/oder Bondbänder notwendig, wodurch ein geringerer technischer Aufwand für einen Herstellungsprozess von Batteriemodulen notwendig ist und einen höheren Automatisierungsgrad ermöglicht.

Vorteilhafterweise wird das Batteriemodul in einer Lithium-Ionen-, einer Lithium-Schwefel- und/oder einer Lithium-Luft-Batterie verwendet.

### Kurzbeschreibung der Figuren

Ausführungsbeispiele der Erfindung sind in der Zeichnung dargestellt und in der nachfolgenden Beschreibung näher erläutert.

Es zeigt:
Figur 1 eine Ausführungsform des erfindungsgemäßen Batteriemodul; und
Figur 2 ein Diagramm der beispielhaften Stromtragfähigkeit in Abhängigkeit eines Durchmessers eines Bonddrahts.

### Detaillierte Beschreibung der Ausführungsbeispiele

Gleiche Bezugszeichen bezeichnen in allen Figuren gleiche Vorrichtungskomponenten.

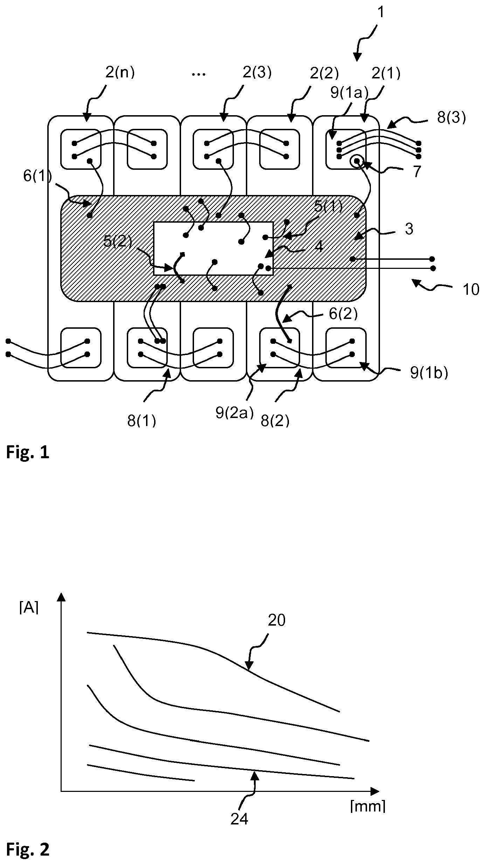

Figur 1 zeigt ein Batteriemodul 1 mit mehreren Batteriezellen 2(1), 2(2), 2(3), 2(n), wobei jede Batteriezelle 2(1), 2(2), 2(3), 2(n) mindestens zwei Zellterminals 9(1a), 9(1b), 9(2a) aufweist.

In Figur 1 ist beispielsweise das Zellterminal 9(1a) mit einem positiven Pol der Batteriezelle 2(1) und das Zellterminal 9(1b) mit einem negativen Pol der Batteriezelle 2(1) mechanisch und elektrisch leitend verbunden. Zellterminals unterschiedlicher Polarität sind mittels mindestens eines Zellverbinders 8(1), 8(2), 8(3) elektrisch leitend miteinander verbunden, beispielsweise ist das Zellterminal 9(1b) der Batteriezelle 2(1) mit dem Zellterminal 9(2a) der Batteriezelle 2(2) verbunden. Die Zellerverbinder 8(1), 8(2), 8(3) sind als Bonddrähte und/oder Bondbänder ausgeführt.

Erfindungsgemäß umfasst das Batteriemodul 1 eine flexible Leiterplatte 3 und eine Zellüberwachungseinheit 4. In der in Figur 1 gezeigten Ausführungsform ist die Zellüberwachungseinheit 4 innerhalb eines Bereichs der flexiblen Leiterplatte 3angeordnet und die flexible Leiterplatte 3 und die Zellüberwachungseinheit 4 sind miteinander verklebt.

In alternativen Ausführungsformen wird eine mechanische Verbindung zwischen der flexiblen Leiterplatte 3 und der Zellüberwachungseinheit 4 durch Verschrauben, Verlöten und/oder Verschweißen erzielt.

In einer weiteren Ausführungsform wird die Zellüberwachungseinheit 4 mittels elektronischer Bauteile direkt auf der flexiblen Leiterplatte 3 umgesetzt, wodurch vorteilhafterweise eine starre Leiterplatte der Zellüberwachungseinheit 4 entfällt.

Gemäß der Erfindung weißt die flexible Leiterplatte 3 und/oder die Zellüberwachungseinheit 4 eine Vorrichtung zum Arretieren auf, so dass die Zellüberwachungseinheit 4 reversibel mit der flexiblen Leiterplatte 3 mechanisch verbunden ist und vorteilhafterweise im Falle eines Defekts getauscht wird.

Die flexible Leiterplatte 3 weist beispielsweise in der gezeigten Ausführungsform Stromschienen und/oder Vorrichtungen zum Ladungsausgleich der Batteriezellen 2(1), 2(2), 2(3), 2(n) auf. Die Zellterminals 9(1a), 9(1b), 9(2a) sind mittels mindestens einem Bonddraht 6(1) und/oder einem Bondband 6(2) elektrisch leitend mit der flexiblen Leiterplatte 4 verbunden, beispielsweise mit den Stromschienen, Leiterbahnen, Kontaktierungsflächen und/oder den Vorrichtungen zum Ladungsausgleich. Vorteilhafterweise ist in der gezeigten Ausführungsform ein Temperatursensor 7 mit der flexiblen Leiterplatte 3 verbunden.

Die Zellüberwachungseinheit 4 umfasst zur Ermittlung von Batteriemoduleigenschaften für das Batteriemodul 1 wie beispielsweise Ladezustand (SOC), Gesundheitszustand (SOH), Innenwiderstand mindestens einen Spannungssensor, einen Stromsensor, einen Temperatursensor, einen Widerstand und/oder ein Batteriemanagementsystem. Die Zellüberwachungseinheit 4 ist mit der flexiblen Leiterplatte 3 mittels mindestens einem Bonddraht 5(1) und/oder einem Bondband 5(2) elektrisch leitend verbunden und kann beispielsweise mittels des Spannungssensor eine Spannung einer einzelnen Batteriezelle 2(1), 2(2), 2(3), 2(n) oder aller Batteriezellen 2(1), 2(2), 2(3), 2(n) erfassen.

Durch die Zellüberwachungseinheit kann vorteilhafterweise die Sicherheit von Batteriemodulen 1 erhöht werden, da Fehler frühzeitig erkannt werden, so dass Sicherheitsmaßnahmen bereits vor Auftreten eines Fehlers ergriffen werden können und beispielsweise einzelne Batteriezellen 2(1), 2(2), 2(3), 2(n) zu- oder abgeschaltet werden.

In einer weiteren Ausführungsform sind die Zellüberwachungseinheit 4 und/oder die flexible Leiterplatte 3 mittels elektrisch leitender Verbindungen und/oder optischer Verbindungen mit weiteren Zellüberwachungseinheiten 4, flexiblen Leiterplatten 3 und/oder Batteriemanagementsystemen verbunden, beispielsweise mittels einer Kabelverbindung und/oder mittels eines Bussystems. Vorteilhafterweise erfasst ein zentrales Batteriemanagementsystem Batteriemoduleigenschaften von mehreren Batteriemodulen 1, um Batterieeigenschaften anhand der Batteriemoduleigenschaften zu ermitteln.

In Figur 2 ist über einer Länge eines Bonddrahts (in Millimetern) eine Stromtragfähigkeit (in Ampere) von einem Verhältnis Durchmesser des Bonddrahts zu Länge des Bonddrahts aufgetragen. Anhand der dargestellten Kurven kann in Abhängigkeit einer notwendigen Stromfestigkeit des Bonddrahts der Durchmesser gewählt werden, so dass eine Gewichtsreduktion durch einen geringeren Materialbedarf und eine Verringerung von Übergangswiderständen erreicht wird. In Figur 2 ist beispielsweise die Stromtragfähigkeit für einen Bonddraht 20 bzw. 24 aus Aluminium mit einem Durchmesser von 500µm bzw. 200µm dargestellt.

Wird eine besonders hohe Anforderung an eine mechanische Stabilität einer Bondverbindung des Bonddrahts gestellt, beispielsweise aufgrund einer hohen Umgebungstemperatur des Batteriemoduls 1 oder durch starke Vibrationen, wird ein größerer Durchmesser des Bonddrahts gewählt, so dass beispielsweise ein Abreißwert bei einem Durchmesser des Bonddrahts von 200µm bei 500cN liegt.

## Patentansprüche

1. Batteriemodul (1) mit mehreren Batteriezellen (2(1), 2(2), 2(3), 2(n)), wobei jede Batteriezelle 2(1), 2(2), 2(3), 2(n) mindestens zwei Zellterminals 9(1a), 9(1b), 9(2a) aufweist, und
wobei Zellterminals 9(1a), 9(1b), 9(2a) unterschiedlicher Polarität mittels mindestens eines Zellverbinders 8(1), 8(2), 8(3) elektrisch leitend miteinander verbunden sind,
wobei das Batteriemodul (1) eine Zellüberwachungseinheit (4) umfasst, **dadurch gekennzeichnet,**
**dass** die Zellüberwachungseinheit (4) mittels mindestens eines Bonddrahts (5(1)) und/oder mindestens eines Bondbands (5(2)) mit einer flexiblen Leiterplatte (3) elektrisch leitend verbunden ist,
wobei die flexible Leiterplatte (3) und/oder die Zellüberwachungseinheit (4) eine Vorrichtung zum Arretieren aufweist, mittels welcher die Zellüberwachungseinheit (4) reversibel mit der flexiblen Leiterplatte (3) mechanisch verbunden ist,
und **dass** die Zellerverbinder 8(1), 8(2), 8(3) als Bonddrähte und/oder Bondbänder ausgeführt sind.

2. Batteriemodul (1) nach Anspruch 1, **dadurch gekennzeichnet, dass** als Material für den Bonddraht (5(1)) und/oder das Bondband (5(2)) Aluminium, Aluminium-Silizium, Kupfer und/oder Gold verwendet wird.

3. Batteriemodul (1) nach einem der vorhergehenden Ansprüche, **dadurch gekennzeichnet, dass** der Bonddraht (5(1)) einen Durchmesser zwischen 100µm und 500µm aufweist.

4. Batteriemodul (1) nach einem der vorhergehenden Ansprüche 1 oder 2, **dadurch gekennzeichnet, dass** das Bondband (5(2)) eine rechteckige Form mit einer Breite zwischen 30µm und 3000µm und einer Höhe zwischen 10µm und 500µm aufweist.

5. Batteriemodul (1) nach einem der vorhergehenden Ansprüche, **dadurch gekennzeichnet, dass** der Bonddraht (5(1)) und/oder das Bondband 5(2)) eine Länge zwischen 1mm und 30mm aufweist.

6. Batteriemodul (1) nach einem der vorhergehenden Ansprüche, **dadurch gekennzeichnet, dass** die Zellüberwachungseinheit (4) mindestens einen Spannungssensor, einen Stromsensor, einen Temperatursensor, einen Widerstand und/oder ein Batteriemanagementsystem umfasst.

7. Batteriemodul (1) nach einem der vorhergehenden Ansprüche, **dadurch gekennzeichnet, dass** die Zellüberwachungseinheit (4) innerhalb eines Bereichs der flexiblen Leiterplatte (3) angeordnet ist und die Zellüberwachungseinheit (4) und die flexible Leiterplatte (3) miteinander verklebt, verschraubt, verlötet und/oder verschweißt und/oder mittels Arretierungen mechanisch verbunden.

8. Batteriemodul (1) nach einem der vorhergehenden Ansprüche, **dadurch gekennzeichnet, dass** die flexible Leiterplatte (3) als Grundmaterial PET (Polyester), PEM (Polyethylennaphtalat) und/oder PI (Polyimid) aufweist.

9. Verfahren zur Herstellung einer elektrisch leitenden Verbindung nach einem der Ansprüche 1 bis 8, **dadurch gekennzeichnet, dass** eine elektrisch leitende Verbindung zwischen der Zellüberwachungseinheit (4) und der flexiblen Leiterplatte (3) mittels Thermosonic-Ball-Wedge-Bonden, Ultraschall-Wedge-Wedge-Bonden und/oder Thermokompressionsbonden mindestens eines Bonddrahts (5(1)) und/oder eines Bondbands (5(2)) hergestellt wird.

10. Verwendung eines Batteriemoduls (1) nach einem der Ansprüche 1 bis 8 für eine Lithium-Ionen-, Lithium-Schwefel- und/oder Lithium-Luft-Batterie.

## Claims

1. Battery module (1) having a plurality of battery cells (2(1), 2(2), 2(3), 2(n)),
wherein each battery cell 2(1), 2(2), 2(3), 2(n) has at least two cell terminals 9(1a), 9(1b), 9(2a), and
wherein cell terminals 9(1a), 9(1b), 9(2a) of different polarity are electrically conductively connected to one another by means of at least one cell connector 8(1), 8(2), 8(3),
wherein the battery module (1) comprises a cell monitoring unit (4),
**characterized**
**in that** the cell monitoring unit (4) is electrically conductively connected to a flexible circuit board (3) by means of at least one bonding wire (5(1)) and/or at least one bonding strip (5(2)),
wherein the flexible circuit board (3) and/or the cell monitoring unit (4) has a locking device by means of which the cell monitoring unit (4) is reversibly mechanically connected to the flexible circuit board (3),
and **in that** the cell connectors 8(1), 8(2), 8(3) are embodied as bonding wires and/or bonding strips.

2. Battery module (1) according to Claim 1, **characterized in that** aluminum, aluminum-silicon, copper and/or gold is used as material for the bonding wire (5(1)) and/or the bonding strip (5(2)).

3. Battery module (1) according to either one of the preceding claims, **characterized in that** the bonding wire (5(1)) has a diameter between 100 µm and 500 µm.

4. Battery module (1) according to either one of the preceding Claims 1 or 2, **characterized in that** the bonding strip (5(2)) has a rectangular shape with a width between 30 µm and 3000 µm and a height between 10 µm and 500 µm.

5. Battery module (1) according to any one of the preceding claims, **characterized in that** the bonding wire (5(1)) and/or the bonding strip (5(2)) have/has a length between 1 mm and 30 mm.

6. Battery module (1) according to any one of the preceding claims, **characterized in that** the cell monitoring unit (4) comprises at least one voltage sensor, a current sensor, a temperature sensor, a resistor and/or a battery management system.

7. Battery module (1) according to any one of the preceding claims, **characterized in that** the cell monitoring unit (4) is arranged within a region of the flexible circuit board (3), and the cell monitoring unit (4) and the flexible circuit board (3) are adhesively bonded, screwed, soldered and/or welded to one another and/or mechanically connected to one another by means of locking mechanisms.

8. Battery module (1) according to any one of the preceding claims, **characterized in that** the flexible circuit board (3) comprises, as base material, PET (polyester), PEM (polyethylene naphthalate) and/or PI (polyimide).

9. Method for producing an electrically conductive connection according to any one of Claims 1 to 8, **characterized in that** an electrically conductive connection is produced between the cell monitoring unit (4) and the flexible circuit board (3) by means of thermosonic ball-wedge bonding, ultrasonic wedge-wedge bonding and/or thermocompression bonding of at least one bonding wire (5(1)) and/or bonding strip (5(2)).

10. Use of a battery module (1) according to any one of Claims 1 to 8 for a lithium-ion, lithium-sulfur and/or lithium-air battery.

## Revendications

1. Module de batterie (1) comportant plusieurs cellules de batterie (2(1), 2(2), 2(3), 2(n)), dans lequel chaque cellule de batterie 2(1), 2(2), 2(3), 2(n) comporte au moins deux bornes de cellule 9(la), 9(lb), 9(2a), et dans lequel des bornes de cellule 9(la), 9(1b), 9(2a) de polarité différente sont reliées électriquement les unes aux autres au moyen d'au moins un connecteur de cellule 8(1), 8(2), 8(3),
dans lequel le module de batterie (1) comprend une unité de surveillance de cellules (4),
**caractérisé en ce que** l'unité de surveillance de cellules (4) est reliée de manière électriquement conductrice à une carte de circuit imprimé flexible (3) au moyen d'au moins un fil de liaison (5(1)) et/ou d'au moins une bande de liaison (5(2)),
dans lequel la carte de circuit imprimé flexible (3) et/ou l'unité de surveillance de cellules (4) comporte un dispositif de blocage au moyen duquel l'unité de surveillance de cellules (4) est reliée mécaniquement de manière réversible à la carte de circuit imprimé flexible (3),
et **en ce que** les connecteurs de cellules 8(1), 8(2) et 8(3) sont réalisés sous la forme de fils de liaison et/ou de bandes de liaison.

2. Module de batterie (1) selon la revendication 1, **caractérisé en ce qu'**on utilise en tant que matériau destiné au fil de liaison (5(1)) et/ou à la bande de liaison (5(2)), de l'aluminium, de l'aluminium-silicium, du cuivre et/ou de l'or.

3. Module de batterie (1) selon l'une des revendications précédentes, **caractérisé en ce que** le fil de on utilise (5(1)) présente un diamètre compris entre 100µm et 500µm.

4. Module de batterie (1) selon l'une des revendications 1 ou 2 précédentes, **caractérisé en ce que** la bande de on utilise (5(2)) présente une forme rectangulaire ayant une largeur comprise entre 30µm et 3000µm et une hauteur comprise entre 10µm et 500µm.

5. Module de batterie (1) selon l'une des revendications précédentes, **caractérisé en ce que** le fil de on utilise (5(1)) et/ou la bande de on utilise (5(2)) présente une longueur comprise entre 1mm et 30mm.

6. Module de batterie (1) selon l'une des revendications précédentes, **caractérisé en ce que** l'unité de surveillance de cellules (4) comprend au moins un capteur de tension, un capteur de courant, un capteur de température, une résistance et/ou un système de gestion de batterie.

7. Module de batterie (1) selon l'une des revendications précédentes, **caractérisé en ce que** l'unité de surveillance de cellules (4) est disposée à l'intérieur d'une zone de la carte de circuit imprimé flexible (3) et **en ce que** l'unité de surveillance de cellules (4) et la carte de circuit imprimé flexible (3) sont collées, vissées, brasées et/ou soudées l'une à l'autre et/ou reliées mécaniquement au moyen de dispositifs de blocage.

8. Module de batterie (1) selon l'une des revendications précédentes, **caractérisé en ce que** la carte de circuit imprimé flexible (3) comporte, en tant que matériau de base, du PET (polyester), du PEM (naphtalate de polyéthylène) et/ou du PI (polyimide).

9. Procédé de fabrication d'une liaison électriquement conductrice selon l'une des revendications 1 à 8, **caractérisé en ce qu'**une liaison électriquement conductrice est réalisée entre l'unité de surveillance de cellules (4) et la carte de circuit imprimé flexible (3) par soudage thermosonore à bille et biseau et/ou par soudage à biseau-biseau par ultrasons, par soudage par thermocompression d'au moins un fil de liaison (5(1)) et/ou d'un ruban de liaison (5(2)).

10. Utilisation d'un module de batterie (1) selon l'une des revendications 1 à 8 pour une batterie au lithium-ion, au lithium-soufre et/ou au lithium-air.
